(19) Europäisches Patentamt
European Patent Office
Office européen des brevets

(11) EP 4 757 180 A1

(12) DEMANDE DE BREVET EUROPEEN

(43) Date de publication:
10.06.2026 Bulletin 2026/24

(21) Numéro de dépôt: 25219814.8

(22) Date de dépôt: 01.12.2025

(51) Classification Internationale des Brevets (IPC):
*H03H 3/02* (2006.01)      *H10N 30/071* (2023.01)

(52) Classification Coopérative des Brevets (CPC):
H10P 90/1916; H03H 3/02; H10N 30/071;
H10W 10/181

(84) Etats contractants désignés:
AL AT BE BG CH CY CZ DE DK EE ES FI FR GB
GR HR HU IE IS IT LI LT LU LV MC ME MK MT NL
NO PL PT RO RS SE SI SK SM TR
Etats d'extension désignés:
BA
Etats de validation désignés:
GE KH LA MA MD TN

(30) Priorité: 06.12.2024 FR 2413534

(71) Demandeur: Commissariat à l'Energie Atomique
et aux Energies
Alternatives
75015 Paris (FR)

(72) Inventeurs:
• BOUSQUET, Marie
38054 Grenoble Cedex 9 (FR)
• REINHARDT, Alexandre
38054 Grenoble Cedex 9 (FR)
• LEFEVRE, Aude
38054 Grenoble Cedex 9 (FR)
• PERREAU, Pierre
38054 Grenoble Cedex 9 (FR)

(74) Mandataire: Germain Maureau
12, rue Boileau
69006 Lyon (FR)

(54) PROCÉDÉ DE CORRECTION D'ÉPAISSEUR D'UNE COUCHE

(57) L'invention concerne un procédé de correction d'épaisseur comprenant successivement une étape de mise à disposition (E0) d'un substrat support (5) comprenant une couche mince (10), ladite couche mince (10) présentant une surface (s10) s'étendant jusqu'à un bord périphérique (b10) ; une étape de gravure (E2), dans laquelle la couche mince (10) est gravée sélectivement par bombardement d'ions localisé, de sorte qu'une épaisseur (e10) de ladite couche mince (10) varie progressivement depuis un centre (C10) la couche mince (10) vers le bord périphérique (b10) ; et une étape de planarisation (E3), dans laquelle la couche mince (10) est polie par polissage mécanochimique, de sorte qu'à l'issue de l'étape de planarisation (E3), la couche mince (10) présente une épaisseur sensiblement constante.

Fig. 4

(A)

(B)

## Description

## Domaine technique de l'invention

La présente invention concerne le domaine de la microélectronique, et plus particulièrement les procédés correction d'épaisseurs des couches minces.

## Etat de la technique

Dans le domaine de la microélectronique, les performances de dispositifs micrométriques fabriqués peuvent dépendre de certains paramètres géométriques d'éléments constitutifs de ces dispositifs. Par exemple dans le cas de résonateurs ou de filtres acoustiques, les performances dépendent des épaisseurs des couches utilisées, et notamment de la couche de matériau piézoélectrique. En effet, son épaisseur ou les variations d'épaisseur de la couche joue un rôle sur la fréquence de résonance ($f_r$), le coefficient de couplage ($k^2$), la largeur de la bande passante (ou bandwidth en anglais), ou son facteur de qualité (Q). Par conséquent, il est crucial de pouvoir maîtriser l'épaisseur (en termes de valeur cible et d'homogénéité) de la couche de matériau piézoélectrique à l'échelle du substrat sur laquelle elle est disposée. Cela est rendu particulièrement difficile par le fait qu'une telle couche présente une faible épaisseur.

De manière plus générale, il est fréquent de vouloir contrôler l'épaisseur d'une couche, et d'en garantir la valeur cible.

Afin de remplir ces objectifs, il est connu de l'état de l'art de corriger l'épaisseur d'une couche mince en utilisant une méthode de gravure localisée (ou trimming en anglais) mise en œuvre après une étape de mesure. Par exemple, la mise en œuvre d'une gravure localisée par bombardement d'ions permet de corriger localement un défaut d'épaisseur pour homogénéiser une couche et atteindre sa valeur cible. Bien qu'une telle méthode donne satisfaction en ce qu'elle permet de rendre une couche plus uniforme et plus proche de l'épaisseur cible désirée, dans le cas de matériaux piézoélectriques, elle engendre la formation d'une couche de matériau amorphe à la surface de la couche qui a besoin ultérieurement d'être enlevée. Cette couche de matériau amorphe peut dégrader les performances des dispositifs micrométriques fabriqués.

Pour supprimer cette couche de matériau amorphe, il est connu de mettre en œuvre, soit un traitement thermique à température comprise entre 200°C et 500°C, soit de réaliser un polissage mécano-chimique (ou Chemical Mechanical Polishing - CMP, en anglais) sur la surface, soit une combinaison des deux.

Bien que ces solutions donnent satisfaction en ce qu'elles permettent de supprimer la couche de matériau amorphe, elles présentent des inconvénients. La mise en œuvre d'un traitement thermique peut provoquer la perte de certains éléments légers dans le matériau, comme par exemple le Lithium (Li), le potassium (K) ou le sodium (Na) qui sont parfois inclus dans les matériaux piézoélectriques. Le polissage mécano-chimique de son côté engendre parfois de la non-uniformité à l'échelle de la surface planarisée.

Il existe donc un besoin de trouver un procédé de correction d'épaisseurs permettant de rendre une couche suffisamment proche de la valeur cible désirée, et ce de manière homogène à l'échelle du substrat sans engendrer la formation d'une couche de matériau amorphe en surface.

## Objet de l'invention

La présente invention a pour but de proposer une solution qui réponde à tout ou partie des problèmes précités.

Ce but peut être atteint grâce à la mise en œuvre d'un procédé de correction d'épaisseurs, le procédé comprenant successivement :

- une étape de mise à disposition d'un substrat support comprenant une couche mince, ladite couche mince présentant une surface s'étendant jusqu'à un bord périphérique ;
- une étape de gravure, dans laquelle la couche mince est gravée sélectivement par bombardement localisé d'ions, de sorte qu'une épaisseur de ladite couche mince varie progressivement depuis un centre de la couche mince vers le bord périphérique ; et
- une étape de planarisation, dans laquelle la couche mince est amincie par polissage mécanochimique, de sorte qu'à l'issue de l'étape de planarisation, la couche mince présente une surface sensiblement plane s'étendant jusqu'au bord périphérique.

Les dispositions précédemment décrites permettent de proposer un procédé de corrections d'épaisseurs qui tire avantage de la gravure localisée lors de l'étape de gravure pour créer une topographie spécifique de la couche mince. L'étape de gravure permet ainsi de préparer la surface de la couche mince pour améliorer l'homogénéité d'épaisseur obtenue lors de l'étape de planarisation. De manière synergique, l'étape de planarisation permet également de supprimer toute couche amorphe déposée incidemment lors de l'étape de gravure.

Le procédé de correction d'épaisseurs peut en outre présenter une ou plusieurs des caractéristiques suivantes, prises seules ou en combinaison.

Selon un mode de réalisation, l'étape de gravure est mise en œuvre par le bombardement d'espèces ioniques, par exemple d'argon (Ar), de trifluorure d'azote ($NHF_3/NF_3$), ou de trifluorométhane ($CHF_4$), etc., sur la surface de la couche mince. Par exemple, le bombardement d'espèces ioniques est réalisé à une énergie comprise entre 0,05 et 3,0 MeV, avec une dose ionique comprise entre $10^{10}$ et $10^{16}$ at/cm$^2$.

Par épaisseur « sensiblement homogène » on entend qu'à l'issue de l'étape de correction d'épaisseurs, la surface de la couche mince présente des variations d'épaisseur inférieures à 1% et/ou un pourcentage de non uniformité inférieur à 1%.

Par exemple il est possible de caractériser l'homogénéité en épaisseur en %, comme étant, pour un ensemble de points répartis sur ladite surface, un ratio de l'écart-type sur la moyenne de l'épaisseur de la couche mince au niveau de chacun de ces points, multiplié par 100 :

$$\%StdD = 100 * \frac{StdD}{Mean}.$$

Par exemple, il est possible de caractériser le pourcentage de non uniformité comme étant, pour un ensemble de points répartis sur ladite surface, un ratio de l'étendue sur deux fois la moyenne de l'épaisseur de la couche mince au niveau de chacun de ces points, multiplié par 100 :

$$\%NonU = 100 * \frac{Range}{2*Mean}.$$

Selon un mode de réalisation, lors de l'étape de mise à disposition, la couche mince présente une épaisseur inférieure à 2 μm, et notamment inférieure à 1 μm.

Ainsi, le procédé de correction d'épaisseurs est adapté pour la correction d'épaisseur de couches dédiées à la réalisation de dispositifs microélectroniques.

Selon un mode de réalisation, l'étape de gravure est mise en œuvre de sorte que le profil d'épaisseur de la couche mince gravée à l'issue de l'étape de gravure présente une forme concave.

Le terme « concave » lié au profil d'épaisseur de la couche mince gravée signifie que l'épaisseur de la couche mince diminue depuis le centre du substrat support jusqu'au bord périphérique.

Ainsi, la couche mince gravée est préparée de sorte que lors de l'étape de planarisation, la couche mince gravée est polie en commençant par le centre. Une telle préparation de la couche mince permet d'obtenir une homogénéité d'épaisseur plus importante suite au polissage que lorsque la couche mince n'est pas gravée sélectivement.

Selon un mode de réalisation, l'étape de gravure est mise en œuvre de sorte que le profil d'épaisseur de la couche mince gravée à l'issue de l'étape de gravure présente une forme convexe.

Le terme « convexe » lié au profil d'épaisseur de la couche mince gravée signifie que l'épaisseur de la couche mince augmente depuis le centre du substrat support jusqu'au bord périphérique.

Ainsi, la couche mince gravée est préparée de sorte que lors de l'étape de planarisation, la couche mince gravée est polie en commençant par le bord périphérique. Une telle préparation de la couche mince permet d'obtenir une homogénéité d'épaisseur plus importante suite au polissage que lorsque la couche mince n'est pas gravée sélectivement.

Selon un mode de réalisation, lors de l'étape de gravure, la couche mince est gravée uniquement du côté de la surface de la couche mince, de sorte qu'une épaisseur de ladite couche mince varie progressivement depuis un centre de la couche mince vers le bord périphérique selon un profil d'épaisseur présentant une forme concave ou convexe, préférentiellement lorsque la face secondaire est sensiblement plane.

Selon un mode de réalisation, la face secondaire est sensiblement plane.

Par « sensiblement plane », on entend que la face secondaire présente une courbure qui est strictement plus faible qu'une courbure de la surface de la couche mince, à l'issue de l'étape de gravure. Par exemple, la face secondaire présente un rayon de courbure qui est strictement plus grand qu'un rayon de courbure de la surface de la couche mince, à l'issue de l'étape de gravure.

Selon un mode de réalisation, le procédé de correction d'épaisseur comprend une sous étape de test, mise en œuvre avant l'étape de gravure, dans laquelle un substrat de test comprenant une couche mince de test est fourni, la couche mince de test étant formée dans un matériau identique à un matériau de la couche mince, la sous étape de test comprenant :

- un amincissement de la couche mince de test par polissage mécanochimique ; puis
- une mesure à différents endroits d'une épaisseur de la couche mince de test, par ellipsométrie ou réflectométrie, de manière à déterminer, pour chacun desdits endroits, une variation d'épaisseur de la couche mince de test ;

l'étape de gravure étant ensuite mise en œuvre en tenant compte de ladite sous étape de test.

Ainsi, il est possible d'adapter l'étape de gravure en fonction du matériau utilisé pour la couche mince.

Selon un mode de réalisation, l'étape de planarisation est mise en œuvre de la même manière que l'amincissement mis en œuvre lors de la sous étape de test.

En d'autres termes, les paramètres et solutions de polissage utilisés lors de la sous étape de test peuvent être utilisés lors de l'étape de planarisation et inversement.

La sous étape de test permet ainsi d'anticiper le résultat de l'étape de planarisation, sur une couche mince de test. Il est ainsi possible d'utiliser les résultats de la sous étape de test pour une grande quantité de couches minces.

Selon un mode de réalisation, le procédé de corrections d'épaisseurs comprend en outre une étape de traitement thermique, mise en œuvre après l'étape de gravure, dans laquelle la couche mince subit un traitement thermique à une température de recuit comprise entre 200°C et 500 °C.

Ainsi, il est possible de supprimer au moins partiellement, une couche de matériau amorphe formée à la surface de la couche mince lors de l'étape de gravure.

Selon un mode de réalisation, la couche mince est une couche de matériau pyroélectrique, ferroélectrique, ou piézoélectrique.

Ainsi, le procédé de correction d'épaisseurs est adapté à la fabrication de dispositifs microélectroniques ou de microsystèmes optiques ou acoustiques.

En particulier, le procédé de planarisation est adapté à la fabrication de résonateurs ou de filtres acoustiques, comme les résonateurs à ondes acoustiques de surface (SAW ou Surface Acoustic Wave en anglais), les résonateurs à ondes de volume (BAW ou Bulk Acoustic Wave en anglais), ou encore les résonateurs à ondes de Lamb (Lamb waves en anglais).

Par exemple, ledit matériau piézoélectrique peut être choisi dans le groupe comprenant : $LiNbO_3$, $LiTaO_3$, $LiNb_{1-x}Ta_xO_3$, quartz ($SiO_2$), $PbZr_{1-x}Ti_xO_3$, $KNbO_3$, $KTaO_3$, $NaNbO_3$, $KNb_{1-x}Ta_xO_3$, $KTa_{1-x}Nb_xO_3$, $BaTiO_3$, $SrTiO_3$, $Ba_{1-x}Sr_xTiO_3$, où $0 \leq x \leq 1$.

Selon un mode de réalisation, la couche mince est une couche monocristalline.

Selon un mode de réalisation, la couche mince comprend le $LiNbO_3$ ou le $LiTaO_3$.

Ainsi, le procédé de fabrication est particulièrement adapté pour la fabrication de résonateurs acoustiques.

Selon un mode de réalisation, le procédé de correction d'épaisseurs comprend en outre une étape de mesure, mise en œuvre avant l'étape de gravure, dans laquelle une mesure à différents endroits d'une épaisseur de la couche mince est réalisée par ellipsométrie ou réflectométrie.

Ainsi, il est possible d'adapter l'étape de gravure en fonction du résultat de l'étape de mesure. Cela permet de former la surface gravée, en limitant au minimum le retrait de matière lors de l'étape de gravure.

Selon un mode de réalisation, l'étape de mesure est réalisée par ellipsométrie, notamment dans le cas où une épaisseur moyenne de la couche mince est inférieure ou égale à 1 $\mu$m.

Selon un mode de réalisation, l'étape de mesure est réalisée par réflectométrie, notamment dans le cas où une épaisseur moyenne de la couche mince est strictement supérieure à 1 $\mu$m.

Par exemple, l'étape de mesure peut être mise en œuvre de sorte à mesurer une épaisseur de la couche mince au niveau de 9 à 121 points distincts choisis sur la surface de la couche mince.

Selon un mode de réalisation, l'étape de mise à disposition comprend les étapes suivantes :

- une étape de fourniture d'un substrat donneur comprenant une couche épaisse, le substrat donneur présentant une surface de collage du côté de la couche épaisse ;
- une étape d'implantation, dans laquelle des espèces légères sont implantées dans la couche épaisse pour y générer un plan de fragilisation et définir ainsi la couche mince entre le plan de fragilisation et la surface de collage du substrat donneur ;
- une étape d'assemblage, dans laquelle la surface de collage du substrat donneur est mise en contact avec une face de réception du substrat support ;
- une étape de détachement, dans laquelle la couche mince est formée par un détachement d'une partie de la couche épaisse au niveau du plan de fragilisation, par l'application d'un traitement thermique.

Les étapes précédemment décrites permettent de prélever une couche mince d'un substrat massif par fracture, par l'utilisation de la technologie Smart Cut™.

Selon un mode de réalisation, lors de l'étape de gravure, une variation de l'épaisseur de la couche mince entre le centre de la couche mince et le bord périphérique est comprise entre 50 nm et 200 nm.

Les gammes d'épaisseur précédemment décrites permettent d'obtenir une bonne préparation de la surface préalablement à la mise en œuvre de l'étape de planarisation, en limitant l'amincissement de la couche mince lors du procédé de planarisation. Il est ainsi possible de conserver un contrôle important sur l'épaisseur de la couche mince, qui est un paramètre particulièrement critique dans la fabrication de résonateurs acoustiques micrométriques.

**Description sommaire des dessins**

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :

La figure 1 est une vue schématique d'une étape de mise à disposition selon un mode de réalisation de l'invention.
La figure 2 est une vue schématique d'une étape de mise à disposition selon un autre mode de réalisation de l'invention, utilisant la technologie SmartCut™.
La figure 3 est une vue schématique d'une étape de mesure selon un mode de réalisation de l'invention.
La figure 4 est une vue schématique de résultat d'une sous étape de test selon un mode de réalisation de l'invention.
La figure 5 est une vue schématique des dernières étapes du procédé de correction d'épaisseurs selon un premier mode de réalisation de l'invention.
La figure 6 est une vue schématique des dernières étapes du procédé de correction d'épaisseurs selon un deuxième mode de réalisation de l'invention.

**Description détaillée**

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux.

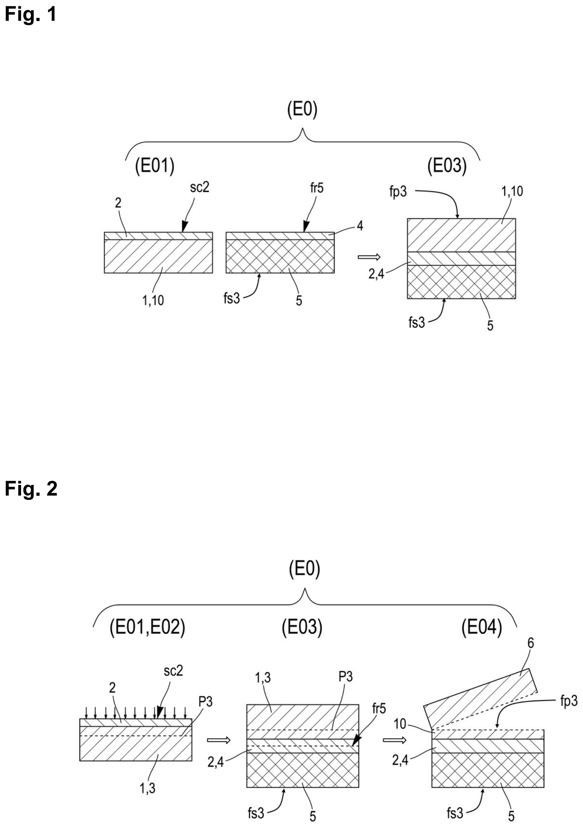

Comme cela est illustré sur les figures 1 à 6, l'invention concerne un procédé de correction de l'épaisseur d'une couche 2. Par « correction d'épaisseur » on entend une méthode consistant à rendre l'épaisseur de la couche 2 sensiblement égale à une valeur cible sur toute la surface du substrat 1. L'atteinte d'une épaisseur visée est un paramètre déterminant pour de nombreuses applications dans le domaine de la microélectronique. Le procédé peut donc être adapté pour différents dispositifs pour lesquels une épaisseur précise est requise.

Le procédé comprend tout d'abord une étape de mise à disposition E0 d'un substrat support 5 comprenant une face principale fp3, et une face secondaire fs3 opposée à la face principale fp3. Le substrat support 5 comprend en outre une couche mince 10 agencée du côté de la face principale fp3. Cette couche mince 10 présente une surface s10 s'étendant jusqu'à un bord périphérique b10. Généralement, la couche mince 10 présente une épaisseur e10 inférieure à 2 $\mu$m, et notamment inférieure à 1 $\mu$m. Les figures 1 et 2 représentent deux modes de mise en œuvre différents de l'étape de mise à disposition E0.

Comme on peut le voir sur la figure 1, une étape de fourniture E01 peut être mise en œuvre, dans laquelle un substrat donneur 1 comprenant une couche mince 10 est fourni. Le substrat donneur 1 peut également comprendre une couche de liaison primaire 2 disposée sur la couche mince 10, qui présente une surface de collage sc2 opposée à la couche mince 10. Ce substrat donneur 1 peut être retourné et rapporté sur une couche de liaison secondaire 4 disposée sur le substrat support 5, lors d'une étape d'assemblage E03. En d'autres termes, lors de cette étape d'assemblage E03, la surface de collage sc2 de la couche de liaison primaire 2 est mise en contact avec une face de réception fr5 du substrat support 5, ladite face de réception fr5 étant formée sur la couche de liaison secondaire 4. L'empilement résultant comprend alors la superposition dans cet ordre du substrat support 5, des couches de liaison primaire et secondaire 2, 4, et de la couche mince 10 dont on veut corriger l'épaisseur. Dans ce cas, le substrat support 5 comprend la face secondaire fs3 opposée aux couches de liaison primaire et secondaire 2, 4. La couche mince 10 forme la face principale fp3, opposée aux couches de liaison primaire et secondaire 2, 4.

La figure 2 illustre un autre mode de mise en œuvre de l'étape de mise à disposition E0 connu sous le nom Smart Cut™. Sommairement, ce mode de réalisation peut comprendre les étapes suivantes.

De la même manière que précédemment, une étape de fourniture E01 est mise en œuvre, dans laquelle un substrat donneur 1 est fourni. Ce substrat donneur 1 comprend une couche épaisse 3, et optionnellement une couche de liaison primaire 2 disposée sur la couche épaisse 3. Le substrat donneur 1 présente ainsi une surface de collage sc2 du côté de la couche épaisse 3, et notamment du côté de la couche de liaison primaire 2.

Une étape d'implantation E02 peut ensuite être mise en œuvre, dans laquelle des espèces chimiques légères sont implantées dans la couche épaisse 3 pour y générer un plan de fragilisation P3. Ce plan de fragilisation P3 délimitera ultérieurement la couche mince 10 avec la face principale fp3.

Une étape d'assemblage E03 est ensuite mise en œuvre par la mise en contact de la surface de collage sc2 du substrat donneur 1 avec une face de réception fr5 du substrat support 5. Comme précédemment, il peut être avantageux que la face de réception fr5 su substrat support soit formé sur une couche de liaison secondaire 4. Un collage est ainsi réalisé entre la surface de collage sc2 et la face de réception fr5 par l'intermédiaire des couches de liaison primaire et secondaire 2, 4.

Enfin, une étape de détachement E04 peut être mise en œuvre. Lors de cette étape, la couche mince 10 est formée par un détachement d'une partie 6 de la couche épaisse 3 au niveau du plan de fragilisation P3, par l'application d'un traitement thermique. Il est donc bien compris que la couche mince 10 est la partie de la couche épaisse 3 qui reste suite au détachement de la partie 6 de la couche épaisse. La face principale fc3 est ainsi formée par la couche mince 10, au niveau du plan de fragilisation P3. Le substrat support 5 peut comprendre la face secondaire fs3 opposée aux couches de liaison primaire et secondaire 2, 4. Les étapes précédemment décrites permettent de prélever une couche mince 10 d'un substrat massif par fracture, par l'utilisation de la technologie Smart Cut™.

Une telle technologie est fréquemment mise en œuvre pour la formation de couche minces de certains matériaux comme par exemple les matériaux pyroélectriques, ferroélectriques, ou piézoélectriques. Il est d'ailleurs possible que la couche mince 10 dont on veut corriger l'épaisseur selon l'invention soit une couche d'un de ces types de matériaux. Il est également possible que la couche mince 10 soit une couche monocristalline. Ainsi, le procédé de correction d'épaisseurs est adapté à la fabrication de dispositifs microélectroniques optiques ou acoustiques. En particulier, le procédé de correction d'épaisseurs est adapté à la fabrication de résonateurs ou de filtres acoustiques, comme les résonateurs à ondes acoustiques de surface (ou SAW, pour Surface Acoustic Wave selon la terminologie anglo-saxonne consacrée), les résonateurs à ondes de volume (ou BAW, pour Bulk Acoustic Wave selon la terminologie anglo-saxonne consacrée), ou encore les résonateurs à ondes de Lamb.

Par exemple, ledit matériau piézoélectrique peut être choisi dans le groupe comprenant : $LiNbO_3$, $LiTaO_3$, $LiNb_{1-x}Ta_xO_3$, quartz ($SiO_2$), $PbZr_{1-x}Ti_xO_3$, $KNbO_3$, $KTaO_3$, $NaNbO_3$, $KNb_{1-x}Ta_xO_3$, $KTa_{1-x}Nb_xO_3$, $BaTiO_3$, $SrTiO_3$, $Ba_{1-x}Sr_xTiO_3$, où $0 \leq x \leq 1$. Plus précisément, la couche mince 10 peut comprendre ou être constituée de $LiNbO_3$, ou de $LiTaO_3$. Ainsi, le procédé de fabrication est particulièrement adapté pour la fabrication de résonateurs acoustiques.

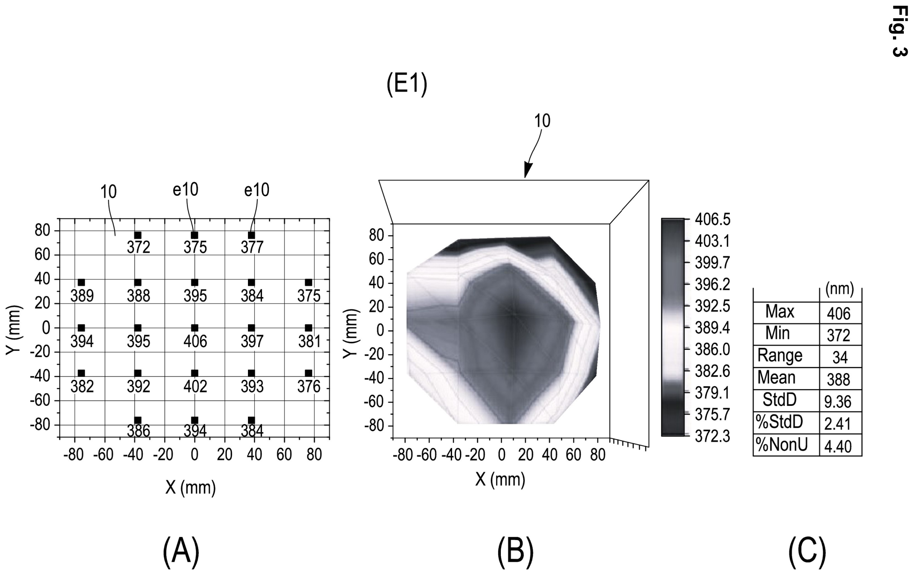

En référence à la figure 3, le procédé de correction d'épaisseurs peut avantageusement comprendre une étape de mesure E1, dans laquelle une mesure de l'épaisseur à différents endroits de la surface s10 de la couche mince 10 est réalisée par ellipsométrie ou réflectométrie. Ainsi, il est possible d'adapter une étape de gravure E2 (qui sera décrite plus loin), en fonction du résultat de l'étape de mesure E1. Cela permet de former la surface s10 gravée, en limitant au minimum le retrait de matière lors de l'étape de gravure E2.

Plus précisément, l'étape de mesure E1 peut être réalisée par ellipsométrie, notamment dans le cas où une épaisseur e10 moyenne de la couche mince 10 est inférieure ou égale à 1 μm, et par réflectométrie, notamment dans le cas où une épaisseur e10 moyenne de la couche mince 10 est strictement supérieure à 1 μm.

Par exemple, l'étape de mesure E1 peut être mise en œuvre de sorte à mesurer une épaisseur e10 de la couche mince 10 au niveau de 9 à 121 points distincts choisis sur la surface s10 de la couche mince 10. La figure 3 illustre une variante dans laquelle l'étape de mesure E1 est réalisée par la mesure de l'épaisseur de la couche mince 10 sur 21 points répartis sur la surface s10 dans le plan formé par les axes X et Y d'une zone de la surface s10 (voir graphe noté A). Il est ainsi possible d'obtenir une distribution de l'épaisseur e10 de la couche mince 10 sur la surface s10 (voir graphe noté B).

Cette étape de mesure E1 permet avantageusement de caractériser l'uniformité de surface %StdD et/ou le pourcentage de non uniformité %NonU. Le tableau noté C présente les valeurs obtenues pour cette étape de mesure. L'uniformité de surface notée « %StdD » en %, est calculé pour être, pour l'ensemble des 21 points répartis sur la surface s10, un ratio de l'écart-type noté « StdD » sur la moyenne notée « Mean » de l'épaisseur e10 de la couche mince 10 au niveau de chacun de ces points, multiplié par 100 :

$$\%StdD = 100 * \frac{StdD}{Mean}$$ . Le pourcentage de non uniformité noté « %NonU » peut être défini comme étant, pour l'ensemble des 21 points répartis sur la surface s10, un ratio de l'étendue notée « Range » sur deux fois la moyenne Mean de l'épaisseur e10 de la couche mince 10 au niveau de chacun de ces points, multiplié par 100 :

$$\%NonU = 100 * \frac{Range}{2*Mean}$$ .

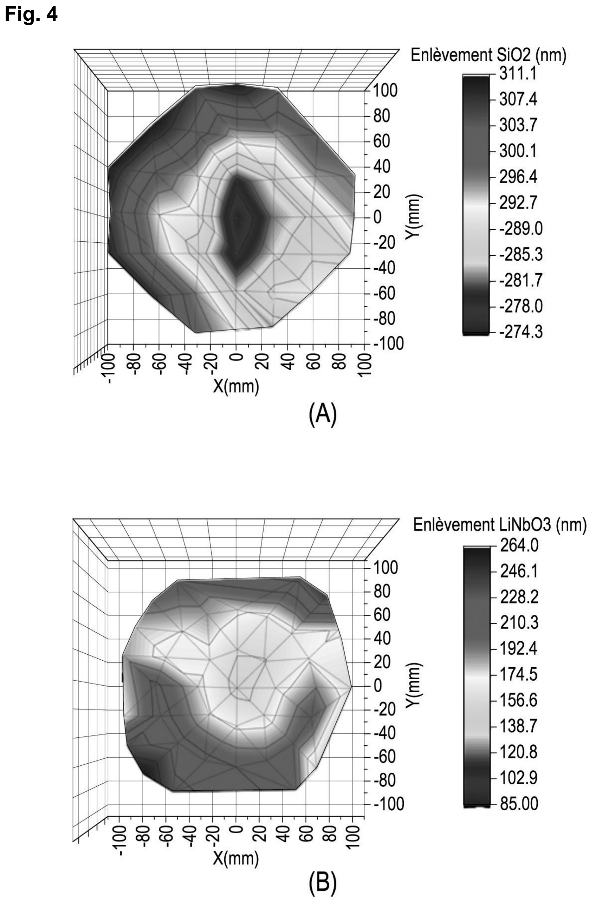

Comme cela est illustré sur la figure 4, le procédé de correction d'épaisseurs peut avantageusement comprendre une sous étape de test E12, mise en œuvre avant une étape de gravure E2 qui sera décrite plus loin. Lors de cette sous étape de test E12, un substrat de test 20 comprenant une couche mince de test 21 est fourni. La couche mince de test 21 est formée dans un matériau identique à un matériau de la couche mince 10. Par exemple, comme cela est illustré sur la figure 4, partie A, la couche mince de test 21 est formée par un oxyde de silicium SiO₂. Alternativement et comme illustré sur la figure 4, partie B, la couche mince de test 21 est formée par le niobate de lithium LiNbO₃. La sous étape de test E12 peut alors comprendre successivement :

- un amincissement de la couche mince de test 21 par polissage mécanochimique ; puis
- une mesure à différents endroits d'une épaisseur de la couche mince de test 21, par ellipsométrie ou réflectométrie, de manière à déterminer, pour chacun desdits endroits, une variation d'épaisseur de la couche mince de test 21.

Ainsi, il est possible de déterminer, en fonction du matériau constitutif de la couche mince 10 et de la couche mince de test 12, quelle sera la variation d'épaisseur obtenue en différents points de la couche mince 10. Comme on peut le voir sur la figure 4, l'amincissement de la couche mince de test 21 pour les deux types de matériaux (partie A et partie B) engendre une variation d'épaisseur plus forte en périphérie de la couche mince que vers le centre. On constate d'ailleurs que la variation d'épaisseur est plus marquée pour une couche mince de test 21 en niobate de lithium LiNbO₃, que pour une couche mince test 21 en oxyde de silicium SiO₂. La sous étape de test E12 permet ainsi d'anticiper le résultat de l'étape de planarisation E3 (décrite ci-après), sur une couche mince de test 21. Il est ainsi possible d'utiliser les résultats de la sous étape de test E12 pour une grande quantité de couches minces 10.

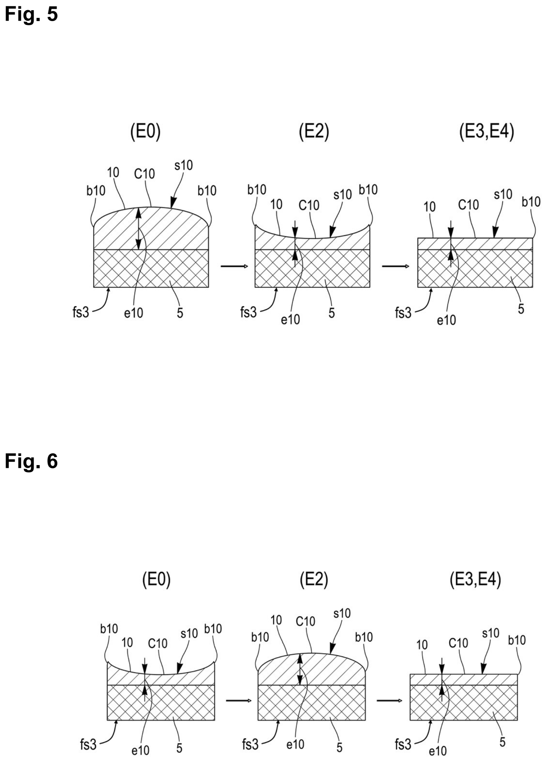

Les figures 5 et 6 illustrent ensuite les étapes restantes du procédé de planarisation, et notamment l'étape de gravure E2, dans laquelle la couche mince 10 est gravée sélectivement par bombardement localisé d'ions et uniquement du côté de la surface s10 de la couche mince 10, de sorte qu'une épaisseur e10 de ladite couche mince 10 varie progressivement depuis un centre C10 de la couche mince 10 vers le bord périphérique b10 selon un profil d'épaisseur. Par exemple, l'étape de gravure E2 est mise en œuvre par le bombardement d'espèces ioniques sur la surface s10 de la couche mince 10. Par exemple, le bombardement d'espèces ioniques comprend le bombardement d'argon (Ar), de trifluorure d'azote (NHF₃/NF₃), ou de trifluorométhane (CHF₄) à une énergie comprise entre 0,05 et 3,0 MeV, avec une dose ionique comprise entre $10^{10}$ et $10^{16}$ at/cm².

Généralement, lors de l'étape de gravure E2, une variation de l'épaisseur e10 de la couche mince 10 entre le centre C10 de la couche mince 10 et le bord périphérique b10 est comprise entre 50 nm et 200 nm. Les gammes d'épaisseur e10 précédemment décrites permettent d'obtenir une bonne préparation de la surface s10 préalablement à la mise en œuvre d'une étape de planarisation E3 (qui sera décrite plus loin), en limitant l'amincissement de la couche mince 10 lors du procédé de planarisation. Il est ainsi possible de conserver un contrôle important sur l'épaisseur e10 de la couche mince 10, qui est un paramètre particulièrement critique dans la fabrication de résonateurs acoustiques micrométriques.

La figure 5 illustre une première variante dans laquelle l'étape de gravure E2 est mise en œuvre de sorte que le profil d'épaisseur de la couche mince 10 gravée à l'issue de l'étape de gravure E2 présente une forme concave. Le terme « concave » lié au profil d'épaisseur de la couche mince 10 gravée signifie que l'épaisseur e10 de la couche mince 10 augmente depuis le centre C10 de la couche mince jusqu'au bord périphérique b10. Ainsi, la couche mince 10 gravée est préparée de sorte que lors de l'étape de planarisation E3, la couche mince 10 gravée est polie en commençant par le bord périphérique b10. Une telle préparation de la couche mince 10 permet d'obtenir une uniformité d'épaisseur plus importante suite au polissage que lorsque la couche mince 10 n'est pas gravée localement au préalable.

Alternativement, et comme représenté sur la figure 6, l'étape de gravure E2 est mise en œuvre de sorte que la couche mince 10 gravée à l'issue de l'étape de gravure E2 présente un profil d'épaisseur de forme convexe. Le terme « convexe » lié au profil d'épaisseur de la couche mince 10 gravée signifie que l'épaisseur e10 de la couche mince 10 diminue depuis le centre C10 du substrat jusqu'au bord périphérique b10. Ainsi, la couche mince 10 gravée est préparée de sorte que lors de l'étape de planarisation E3, la couche mince 10 gravée est polie en commençant par le centre C10. Une telle préparation de la couche mince 10 permet d'obtenir une uniformité de surface plus importante suite au polissage que lorsque la couche mince 10 n'est pas gravée sélectivement.

Quelle que soit la variante utilisée, si une sous étape de test E12 est mise en œuvre, il est possible que l'étape de gravure 2 soit mise en œuvre en tenant compte de ladite sous étape de test 12. Par exemple, il est possible de générer une courbure concave ou convexe qui dépend de la variation d'épaisseur mesurée lors de la sous étape de test E12. Une courbure concave ou une courbure convexe plus forte peut ainsi être mise en œuvre si jamais une variation forte d'épaisseur de la couche mince de test 21 est mesurée. Par exemple une courbure concave ou une courbure convexe peut être proportionnelle à une variation forte d'épaisseur de la couche mince de test 21 mesurée lors de la sous étape de test E12. Ainsi, il est possible d'adapter l'étape de gravure E2 en fonction du matériau utilisé pour la couche mince 10.

Généralement, lors de l'étape de gravure E4, la couche mince 10 est gravée uniquement du côté de la surface s10 de la couche mince 10, de sorte que la face secondaire fs3 reste sensiblement plane. Par « sensiblement plane », on entend que la face secondaire fs3 présente une courbure qui est strictement plus faible qu'une courbure de la surface s10 de la couche mince 10. Par exemple, la face secondaire fs3 présente un rayon de courbure qui est strictement plus grand qu'un rayon de courbure de la surface s10 de la couche mince 10.

Le procédé de correction d'épaisseurs comprend ensuite une étape de planarisation E3, dans laquelle la couche mince 10 est amincie par polissage mécanochimique, de sorte qu'à l'issue de l'étape de planarisation E3, la couche mince 10 présente une épaisseur e10 sensiblement égale à une épaisseur cible, de manière uniforme, jusqu'au bord périphérique b10. Par épaisseur e10 sensiblement uniforme on entend qu'à l'issue de l'étape de planarisation E3, la couche mince 10 présente une uniformité d'épaisseur %StdD inférieure à 1% et/ou un pourcentage de non uniformité %NonU inférieur à 1%. Une telle étape de planarisation E3 peut par exemple être mise en œuvre en utilisant une solution de polissage à base de particules, comme des particules de silice ($SiO_2$), ou d'alumine ($Al_2O_3$) ; en solution basique (ammoniaque, potasse...). Le polissage peut être réalisé avec une pression comprise entre 1 psi et 7 psi, où 1 psi est sensiblement égal à 6894,76 Pa ; et avec des vitesses de rotation de la tête de polissage et du plateau comprise entre 30 RPM et 150 RPM, où 1 RPM est un tour par minute.

Dans le cas où le procédé de correction d'épaisseur comprend une sous étape de test E12, l'étape de planarisation E3 est idéalement mise en œuvre de la même manière que l'amincissement mis en œuvre lors de la sous étape de test E12. En d'autres termes, les paramètres et solutions de polissage utilisés lors de la sous étape de test E12 peuvent être utilisés lors de l'étape de planarisation E3 et inversement.

Enfin, le procédé de planarisation peut avantageusement comprendre une étape de traitement thermique E4, mise en œuvre après l'étape de gravure E2, dans laquelle la couche mince 10 subit un traitement thermique à une température de recuit comprise entre 200°C et 500 °C. Ainsi, il est possible de supprimer au moins partiellement, toute couche de matériau amorphe formée à la surface s10 de la couche mince 10 lors de l'étape de gravure E2.

L'ensemble des dispositions précédemment décrites permettent de proposer un procédé de correction d'épaisseur qui tire avantage de la gravure localisée lors de l'étape de gravure E2 pour créer une topographie spécifique de la couche mince 10. L'étape de gravure E2 permet ainsi de préparer la surface s10 de la couche mince 10 pour améliorer l'uniformité d'épaisseur obtenue lors de l'étape de planarisation E3. De manière synergique, l'étape de planarisation E3 permet également de supprimer toute couche amorphe déposée incidemment lors de l'étape de gravure E2.

## Revendications

1. Procédé de correction d'épaisseur, le procédé comprenant successivement :

   - une étape de mise à disposition (E0) d'un substrat support (5) comprenant une face principale (fp3) et une face secondaire (fs3) opposée à la face principale (fp3), le substrat support (5) comprenant une couche mince (10) agencée du côté de la face principale (fp3), ladite couche mince (10) présentant une surface (s10) s'étendant jusqu'à un bord périphérique (b10) ;
- une étape de gravure (E2), dans laquelle la couche mince (10) est gravée de manière localisée par bombardement localisé d'ions et uniquement du côté de la surface (s10) de la couche mince (10), de sorte qu'une épaisseur (e10) de ladite couche mince (10) varie progressivement depuis un centre (C10) de la couche mince (10) vers le bord périphérique (b10) selon un profil d'épaisseur, et de sorte que le profil d'épaisseur de la couche mince (10) gravée à l'issue de l'étape de gravure (E2) présente une forme concave ou convexe ; et
- une étape de planarisation (E3), dans laquelle la couche mince (10) est amincie par polissage mécanochimique, de sorte qu'à l'issue de l'étape de planarisation (E3), la couche mince (10) présente une épaisseur sensiblement constante.

2. Procédé de correction d'épaisseur selon la revendication 1, comprenant une sous étape de test (E12), mise en œuvre avant l'étape de gravure (E2), dans laquelle un substrat de test (20) comprenant une couche mince de test (21) est fourni, la couche mince de test (21) étant formée dans un matériau identique à un matériau de la couche mince (10), la sous étape de test (E12) comprenant :

- un amincissement de la couche mince de test (21) par polissage mécanochimique ; puis
- une mesure à différents endroits d'une épaisseur de la couche mince de test (21), par ellipsométrie ou réflectométrie, de manière à déterminer, pour chacun desdits endroits, une variation d'épaisseur de la couche mince de test (21) ;

l'étape de gravure (E2) étant ensuite mise en œuvre en tenant compte de ladite sous étape de test (E12).

3. Procédé de correction d'épaisseur selon la revendication 2, dans laquelle l'étape de planarisation (E3) est mise en œuvre de la même manière que l'amincissement mis en œuvre lors de la sous étape de test (E12).

4. Procédé de correction d'épaisseur selon l'une quelconque des revendications 1 à 3, dans lequel lors de l'étape de mise à disposition (E0), la couche mince (10) présente une épaisseur (e10) inférieure à 2 μm, et notamment inférieure à 1 μm.

5. Procédé de correction d'épaisseur selon l'une quelconque des revendications 1 à 4, comprenant en outre une étape de traitement thermique (E4), mise en œuvre après l'étape de gravure (E2), dans laquelle la couche mince (10) subit un traitement thermique à une température de recuit comprise entre 200°C et 500 °C.

6. Procédé de correction d'épaisseur selon l'une quelconque des revendications 1 à 5, dans lequel la couche mince (10) est une couche de matériau pyroélectrique, ferroélectrique, ou piézoélectrique.

7. Procédé de correction d'épaisseur selon la revendication 6, dans lequel la couche mince (10) comprend le $LiNbO_3$, ou le $LiTaO_3$.

8. Procédé de correction d'épaisseur selon l'une quelconque des revendications 1 à 7, comprenant en outre une étape de mesure (E1), mise en œuvre avant l'étape de gravure (E2), dans laquelle une mesure à différents endroits d'une épaisseur de la couche mince (10) est réalisée par ellipsométrie ou réflectométrie.

9. Procédé de correction d'épaisseur selon l'une quelconque des revendications 1 à 8, dans lequel l'étape de mise à disposition (E0) comprend les étapes suivantes :

- une étape de fourniture (E01) d'un substrat donneur (1) comprenant une couche épaisse (3), le substrat donneur (1) présentant une surface de collage (sc2) du côté de la couche épaisse (3) ;
- une étape d'implantation (E02), dans laquelle des espèces légères sont implantées dans la couche épaisse (3) pour y générer un plan de fragilisation (P3) et définir ainsi la couche mince (10) entre le plan de fragilisation (P3) et la surface de collage (sc2) du substrat donneur (1) ;
- une étape d'assemblage (E03), dans laquelle la surface de collage (sc2) du substrat donneur (1) est mise en contact avec une face de réception (fr5) du substrat support (5) ;
- une étape de détachement (E04), dans laquelle la couche mince (10) est formée par un détachement d'une partie (6) de la couche épaisse (3) au niveau du plan de fragilisation (P3), par l'application d'un traitement thermique.

10. Procédé de correction d'épaisseur selon l'une quelconque des revendications 1 à 9, dans lequel lors de l'étape de gravure (E2), une variation de l'épaisseur (e10) de la couche mince (10) entre le centre (C10) de la couche mince (10) et le bord périphérique (b10) est comprise entre 50 nm et 200 nm.

**Fig. 1**

**Fig. 2**

(E1)

(A)　　　　(B)　　　　(C)

Fig. 3

EP 4 757 180 A1

**Fig. 4**

Enlèvement SiO2 (nm)

| |
|---|
| 311.1 |
| 307.4 |
| 303.7 |
| 300.1 |
| 296.4 |
| 292.7 |
| -289.0 |
| -285.3 |
| -281.7 |
| -278.0 |
| -274.3 |

(A)

Enlèvement LiNbO3 (nm)

| |
|---|
| 264.0 |
| 246.1 |
| 228.2 |
| 210.3 |
| 192.4 |
| 174.5 |
| 156.6 |
| 138.7 |
| 120.8 |
| 102.9 |
| 85.00 |

(B)

**Fig. 5**

(E0)   (E2)   (E3,E4)

**Fig. 6**

(E0)   (E2)   (E3,E4)

Europäisches
Patentamt

European
Patent Office

Office européen
des brevets

# RAPPORT DE RECHERCHE EUROPEENNE

Numéro de la demande

EP 25 21 9814

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EP 1 528 591 A2 (SUMITOMO ELECTRIC INDUSTRIES [JP]) 4 mai 2005 (2005-05-04)<br>* alinéa [0005] - alinéa [0011]; revendications 1-2; figures 1-3,5A,5B *<br>* alinéa [0036] - alinéa [0045] *<br>* alinéa [0077] *<br>* alinéa [0091] - alinéa [0117] *<br>----- | 1-10 | INV.<br>H03H3/02<br>H10N30/071 |
| X | FR 3 102 776 A1 (SAINT GOBAIN LUMILOG [FR]) 7 mai 2021 (2021-05-07)<br>* alinéa [0023] - alinéa [0032]; figures 1A,1B,2C,2D,5 *<br>* alinéa [0084] - alinéa [0088] *<br>* alinéa [0115] - alinéa [0133] *<br>----- | 1-10 | |

DOMAINES TECHNIQUES
RECHERCHES (IPC)

H03H

Le présent rapport a été établi pour toutes les revendications

| Lieu de la recherche | Date d'achèvement de la recherche | Examinateur |
|---|---|---|
| Munich | 27 mars 2026 | Mesplede, Delphine |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons
............................................................................................
& : membre de la même famille, document correspondant

EPO FORM 1503 03.82 (P04C02)

**EP 4 757 180 A1**

## ANNEXE AU RAPPORT DE RECHERCHE EUROPEENNE
## RELATIF A LA DEMANDE DE BREVET EUROPEEN NO.

EP 25 21 9814

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

27-03-2026

| Document brevet cité au rapport de recherche | | Date de publication | Membre(s) de la famille de brevet(s) | | Date de publication |
|---|---|---|---|---|---|
| EP  1528591 | A2 | 04-05-2005 | CN | 1612290 A | 04-05-2005 |
| | | | CN | 101339926 A | 07-01-2009 |
| | | | EP | 1528591 A2 | 04-05-2005 |
| | | | JP | 4232605 B2 | 04-03-2009 |
| | | | JP | 2005136167 A | 26-05-2005 |
| | | | KR | 20050041988 A | 04-05-2005 |
| | | | TW | I352379 B | 11-11-2011 |
| | | | US | 2005093101 A1 | 05-05-2005 |
| | | | US | 2007167021 A1 | 19-07-2007 |
| | | | US | 2007284696 A1 | 13-12-2007 |
| | | | US | 2009029550 A1 | 29-01-2009 |
| | | | US | 2012021591 A1 | 26-01-2012 |
| ------- | | | | | -------- |
| FR  3102776 | A1 | 07-05-2021 | EP | 4055214 A1 | 14-09-2022 |
| | | | FR | 3102776 A1 | 07-05-2021 |
| | | | KR | 20220093367 A | 05-07-2022 |
| | | | US | 2022282397 A1 | 08-09-2022 |
| | | | WO | 2021089947 A1 | 14-05-2021 |
| ------- | | | | | -------- |

EPO FORM P0460

Pour tout renseignement concernant cette annexe : voir Journal Officiel de l'Office européen des brevets, No.12/82